# EUROPEAN PATENT APPLICATION

(11) **EP 2 827 377 A1**
(43) Date of publication of application: **21.01.2015**
(21) Application number: 12871482.1
(22) Date of filing: 16.03.2012
(51) Int. Cl.: H01L 31/042

(54) **SOLAR CELL MODULE**

(71) Applicant: Sanyo Electric Co., Ltd., Moriguchi-shi, Osaka 570-8677 (JP)
(72) Inventor: IMADA, Naoto, Moriguchi-shi Osaka 570-8677 (JP); ISHIGURO, Tasuku, Moriguchi-shi Osaka 570-8677 (JP)
(74) Representative: Glawe, Delfs, Moll
(86) International application number: PCT/JP2012/056872
(87) International publication number: WO 2013/136513

(57) **Abstract**

A solar cell module includes a solar cell, a light-receiving surface member on a light-receiving side of the solar cell, a rear surface member on a rear side of the solar cell, and a sealing material between the light-receiving surface member and the rear surface member. The rear surface member has higher permeability of acetic acid than that of the light-receiving surface member. The sealing material seals the solar cell and includes a light-receiving side sealing material on the light-receiving side of the solar cell and a rear side sealing material on the rear side of the solar cell. The light-receiving side sealing material does not contain an ethylene-vinyl acetate copolymer. The rear side sealing material contains the ethylene-vinyl acetate copolymer.

## Description

### TECHNICAL FIELD

The invention relates to a solar cell module.

### BACKGROUND ART

Patent Document 1 discloses a solar cell module in which solar cells are disposed between a transparent light-receiving side sealing material containing an ethylene-vinyl acetate copolymer (EVA) and a white-colored rear side sealing material containing the ethylene-vinyl acetate copolymer.

### PRIOR ART DOCUMENT

### PATENT DOCUMENT

Patent Document 1: Japanese Patent Application Publication No. 2005-50928

### SUMMARY OF THE INVENTION

### PROBLEM TO BE SOLVED BY THE INVENTION

There is a demand for further improvement of the reliability of a solar cell module.

Amain objective of the invention is to provide a solar cell module with improved reliability.

### MEANS FOR SOLVING THE PROBLEM

A solar cell module according to the invention is provided with a solar cell, a light-receiving surface member, a rear surface member, and a sealing material. The light-receiving surface member is disposed on a light-receiving side of the solar cell. The rear surface member is disposed on a rear side of the solar cell. The rear surface member has higher permeability of acetic acid than that of the light-receiving surface member. The sealing material is disposed between the light-receiving surface member and the rear surface member. The sealing material seals the solar cell. The sealing material includes a light-receiving side sealing material and a rear side sealing material. The light-receiving side sealing material is positioned on the light-receiving side of the solar cell. The light-receiving side sealing material does not contain an ethylene-vinyl acetate copolymer. The rear side sealing material is positioned on the rear side of the solar cell. The rear side sealing material contains the ethylene-vinyl acetate copolymer.

### EFFECT OF THE INVENTION

The invention can provide a solar cell module with improved reliability.

### BRIEF DESCRIPTION OF THE DRAWINGS

[Fig. 1] Fig. 1 is a schematic plan view of a solar cell module according to an embodiment of the invention.
[Fig. 2] Fig. 2 is a schematic cross-sectional view of a line II-II part in Fig. 1.
[Fig. 3] Fig. 3 is a graph illustrating Pmax of solar cell modules according to an example and a comparative example.

### MODE FOR CARRYING OUT THE INVENTION

Hereinafter, examples of preferred embodiments carrying out the invention are described. It should be noted that the following embodiments are provided just for illustrative purposes. The invention should not be limited at all to the following embodiments.

In the drawings referred to in the embodiments and other parts, components having substantially the same function are referred to with the same reference numeral. In addition, the drawings referred to in the embodiments and other parts are illustrated schematically, and the dimensional ratio and the like of objects depicted in the drawings are different from those of actual objects in some cases. The dimensional ratio and the like of objects are also different among the drawings in some cases. The specific dimensional ratio and the like of objects should be determined with the following description taken into consideration.

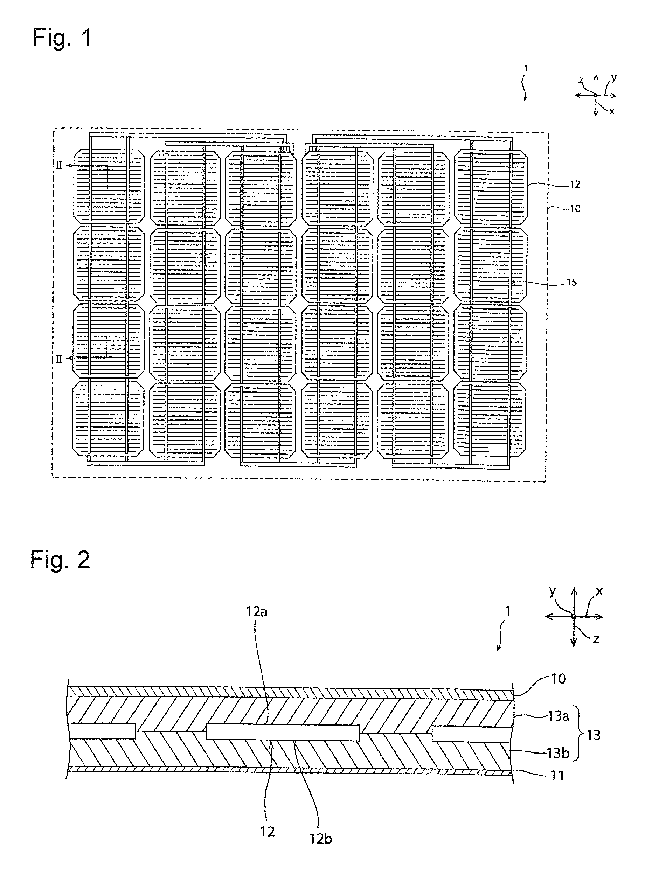

As illustrated in Fig. 1 and Fig. 2, solar cell module 1 includes multiple solar cells 12 electrically connected to one another with wiring materials 15. Multiple solar cells 12 are disposed at intervals in a matrix. Meanwhile, a solar cell module may be provided with only one solar cell.

The type of solar cell 12 is not specially limited. Solar cell 12 can be formed of, for example, a crystal silicon solar cell, a thin-film solar cell, or the like. Solar cell 12 may generate power only when light is received on light-receiving surface 12a. Solar cell 12 may be a bifacial solar cell that generates power not only when light is received on light-receiving surface 12a but also when light is received on rear surface 12b. Herein, the "light-receiving surface" indicates a major surface on which light is mainly received.

Light-receiving surface member 10 is disposed on a light-receiving surface 12a side of solar cell 12. Light-receiving surface member 10 can be formed of, for example, a glass plate, a ceramic plate, or an acrylic resin plate. Rear surface member 11 is disposed on a rear surface 12b side of solar cell 12. Rear surface member 11 can be formed of a resin sheet, for example. Rear surface member 11 does not include a barrier layer such as a metal layer or an inorganic oxide layer. Sealing material 13 is disposed between light-receiving surface member 10 and rear surface member 11. Sealing material 13 seals solar cells 12.

Sealing material 13 includes light-receiving side sealing material 13a and rear side sealing material 13b. Rear side sealing material 13b is positioned at a side of rear surface 12b of solar cell 12. Rear side sealing material 13b contains an ethylene-vinyl acetate copolymer that is a cross-linking resin. Rear side sealing material 13b may be made of an ethylene-vinyl acetate copolymer, or may be made of a resin composition containing an ethylene-vinyl acetate copolymer.

Light-receiving side sealing material 13a is positioned at a side of light-receiving surface 12a of solar cell 12. Light-receiving side sealing material 13a does not contain an ethylene-vinyl acetate copolymer. Light-receiving side sealing material 13a can be made of, for example, polyolefin that is a non-crosslinking resin, or a resin composition containing polyolefin.

In solar cell module 1, rear side sealing material 13b contains an ethylene-vinyl acetate copolymer that is a cross-linking resin. This results in the low fluidity of rear side sealing material 13b under high temperature. Therefore, even when the temperature in solar cell module 1 is raised, solar cells 12 are less likely to be displaced. Thus, a solar cell module with improved reliability can be obtained.

In solar cell module 1, the permeability of acetic acid of rear surface member 11 is higher than that of light-receiving surface member 10. Accordingly, acetic acid generated in rear side sealing material 13b containing an ethylene-vinyl acetate copolymer is easily discharged through rear surface member 11 to the outside of solar cell module 1. Moreover, light-receiving side sealing material 13a does not contain an ethylene-vinyl acetate copolymer. Accordingly, no acetic acid is substantially generated in light-receiving side sealing material 13a. Thus, the concentration of the acetic acid in sealing material 13 is less likely to increase. Thus, solar cells 12 and the like are resistant to deterioration due to the acetic acid. This leads to achievement of improved reliability.

The permeability of acetic acid of rear surface member 11 is preferably higher than that of light-receiving side sealing material 13a. In this case, the acetic acid is easily discharged through rear surface member 11, and the acetic acid is less likely to enter light-receiving side sealing material 13a. Thus, solar cells 12 and the like are resistant to deterioration due to the acetic acid. This can achieve the improved reliability.

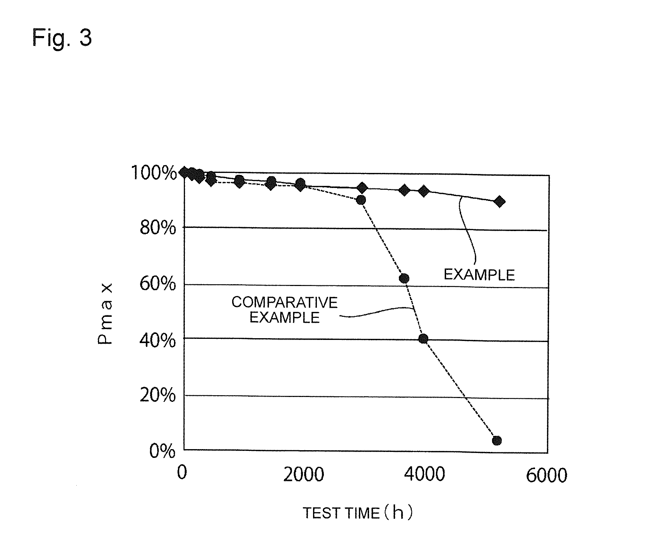

A graph illustrated by a solid line in Fig. 3 is a graph representing the maximum output (Pmax) when a solar cell module according to an example under the following conditions is held in an atmosphere at temperature of 85°C and at humidity of 85%. A graph illustrated by a dashed line in Fig. 3 is a graph representing the maximum output when a solar cell module according to a comparative example in which only a rear surface member is different from that of the solar cell module according to the example is held in the atmosphere at temperature of 85°C and at humidity of 85%. A longitudinal axis in the graph illustrated in Fig. 3 represents the maximum output when Pmax of the solar cell module in the holding time being zero is 100%. A horizontal axis represents the holding time in the atmosphere at temperature of 85°C and at humidity of 85%.

### (Example)

Light-receiving surface member: a glass plate
Rear surface member: a PET sheet of a single layer
Light-receiving side sealing material: polyolefin
Rear side sealing material: an ethylene-vinyl acetate copolymer

### (Comparative Example)

Rear surface member: a laminated PET sheet containing an inorganic oxide layer as a barrier layer

In the example, the permeability of acetic acid of the rear surface member is higher than that of the light-receiving surface member. Moreover, the permeability of acetic acid of the rear surface member is higher than that of the light-receiving side sealing material.

Meanwhile, in the comparative example, the permeability of acetic acid of the rear surface member is lower than that of the light-receiving side sealing material.

From the result illustrated in Fig. 3, it is understood that making the permeability of acetic acid of the rear surface member higher than that of the light-receiving side sealing material makes it possible to suppress a time-dependent decrease of the output characteristic of the solar cell module, and therefore achieve the improved reliability.

Note that, the permeability of acetic acid of rear surface member 11 and light-receiving side sealing material 13a can be determined by using solubility parameters (SP values). For example, the permeability of acetic acid of rear surface member 11 being higher than that of light-receiving side sealing material 13a indicates that an SP value of rear surface member 11 is closer to an SP value of acetic acid than an SP value of light-receiving side sealing material 13a is.

Specifically, the SP value of the acetic acid is 10.1 (cal/cm³)^{1/2}. Accordingly, when light-receiving side sealing material 13a contains polyolefin having an SP value of 7.7 to 8.4 (cal/cm³)^{1/2}, rear surface member 11 is preferably made of a material having an SP value of 8.5 to 12 (cal/cm³)^{1/2}. As such materials, for example, preferably contained is at least any one of polyethylene terephthalate, polybutylene terephthalate, polyethylene naphthalate, polymethyl acrylate, polyamide, polyimide, and polymethyl acrylate. Moreover, when light-receiving side sealing material 13a contains polymethyl acrylate having an SP value of 9.0 to 9.2 (cal/cm³)^{1/2}, rear surface member 11 is preferably made of a material having an SP value of 9.5 to 11

(cal/cm³)^{1/2}. Rear surface member 11 preferably contains, as such a material, for example, at least any one of polyethylene terephthalate, polybutylene terephthalate, polyethylene naphthalate, and polyamide. In these cases, the SP value of rear surface member 11 is closer to the SP value of the acetic acid than the SP value of light-receiving side sealing material 13a is. Accordingly, rear surface member 11 has higher permeability of acetic acid than light-receiving side sealing material 13a.

### EXPLANATION OF THE REFERENCE NUMERALS

- 1: solar cell module
- 10: light-receiving surface member
- 11: rear surface member
- 12: solar cell
- 12a: light-receiving surface
- 12b: rear surface
- 13: sealing material
- 13a: light-receiving side sealing material
- 13b: rear side sealing material

## Claims

1. A solar cell module comprising:
a solar cell;
a light-receiving surface member disposed on a light-receiving side of the solar cell;
a rear surface member disposed on a rear side of the solar cell, and having higher permeability of acetic acid than that of the light-receiving surface member; and
a sealing material disposed between the light-receiving surface member and the rear surface member, and sealing the solar cell, wherein,
the sealing material includes:
a light-receiving side sealing material positioned on the light-receiving side of the solar cell, and does not contain an ethylene-vinyl acetate copolymer; and
a rear side sealing material positioned on the rear side of the solar cell, and contains the ethylene-vinyl acetate copolymer.

2. The solar cell module according to claim 1, wherein,
the permeability of acetic acid of the rear surface member is higher than that of the light-receiving side sealing material.

3. The solar cell module according to claim 1 or 2, wherein
the rear surface member is a resin sheet.

4. The solar cell module according to claim 3, wherein,
the light-receiving side sealing material contains polyolefin, and
the rear surface member contains at least any one of polyethylene terephthalate, polybutylene terephthalate, polyethylene naphthalate, polymethyl acrylate, polyamide, polyimide, and polymethyl acrylate.

5. The solar cell module according to claim 3, wherein,
the light-receiving side sealing material contains polymethyl acrylate, and
the rear surface member contains at least any one of polyethylene terephthalate, polybutylene terephthalate, polyethylene naphthalate, and polyamide.

6. The solar cell module according to any one of claims 1 to 5, wherein
the light-receiving surface member is a glass plate, a ceramic plate, or an acrylic resin plate.
